# FASCICULE DE BREVET EUROPEEN

(11) **EP 0 575 606 B1**
(45) Date de publication et mention de la délivrance du brevet: **20.12.1995**
(21) Numéro de dépôt: 93904083.8
(22) Date de dépôt: 14.01.1993
(51) Int. Cl.: H05K 5/00

(54) **BOITIER RECEPTEUR DE COMPOSANTS ELECTRONIQUES DISSIPATEURS**
GEHÄUSE FÜR WÄRMEERZEUGENDE ELEKTRONISCHE BAUTEILE.
HOUSING FOR DISSIPATIVE ELECTRONIC COMPONENTS

(30) Priorité: 14.01.1992 FR 9200297
(43) Date de publication de la demande: 29.12.1993
(73) Titulaire: SOCIETE D'APPLICATIONS GENERALES D'ELECTRICITE ET DE MECANIQUE SAGEM, F-75783 Paris Cédex 16 (FR)
(72) Inventeur: LANOE, Thierry, F-95000 Cergy (FR)
(74) Mandataire: Bloch, Gérard
(86) Numéro de dépôt international: FR9300037
(87) Numéro de publication internationale: WO9314614

(56) Documents cités:
- DE-C- 4 023 319
- US-A- 4 339 260
- US-A- 5 103 375

## Description

La présente invention concerne un boîtier récepteur de composants électroniques dissipateurs d'énergie montés sur un circuit imprimé double face qui est fixé à un substrat métallique de drainage thermique solidaire du boîtier et auquel est relié électriquement un connecteur aussi solidaire du boîtier et disposé du même côté du substrat que le circuit imprimé.

US-A-4 339 260 révèle un système de refroidissement dans lequel un panneau métallique est fixé à une plaque de circuit imprimé double face. Le panneau métallique comporte une découpe permettant le montage d'un connecteur sur la plaque de circuit imprimé.

L'utilisation d'un circuit imprimé sur substrat métallique de drainage thermique est aujourd'hui assez fréquemment proposée comme solution au problème de la dissipation thermique de composants de puissance. De part et d'autre d'une couche peu épaisse souple, ou flexible, en matière isolante du type polymide ou de la marque Kapton, on imprime deux ensembles de pistes en cuivre et on colle le circuit double face ainsi formé sur le substrat métallique. On parle alors d'un support flexible de puissance (power flex board) qu'on rencontre par exemple dans le domaine de l'électronique automobile. Ce domaine, comme d'autres d'ailleurs, exige des produits, bien que soumis à des conditions d'utilisation sévères, d'une excellente fiabilité et de faible coût. La température est un des facteurs affectant cette fiabilité. Pour considérer l'exemple de commutateurs électroniques associés à des actionneurs de puissance pilotés par calculateur électronique, ils dissipent de l'énergie et il faut absolument les refroidir pour préserver leur fiabilité. Les supports flexibles de puissance, tels que définis ci-dessus, assurent le refroidissement nécessaire.

Subsiste un problème, la pose du connecteur. On a déjà proposé d'adopter un connecteur de type CMS (composant monté en surface), mais il est difficile à souder du même côté du substrat métallique que le support flexible, le circuit imprimé et ses composants ne supportant pas deux soudages. On a aussi déjà proposé de souder les pattes de connexion d'un connecteur classique sur un bord du support flexible, en saillie hors du substrat métallique puis d'introduire l'ensemble support-connecteur dans le boîtier et enfin de fixer l'un et l'autre au boîtier par vis, clips ou autres moyens analogues. Mais cette solution présente aussi des inconvénients. Compte-tenu de l'absence de rigidité de l'ensemble support-connecteur entre le moment de son assemblage, par soudage des connexions, et le moment de sa fixation, il subit des contraintes. La résistance thermique entre le substrat métallique du support et le boîtier est préjudiciable a la fiabilité des moyens de contrôle et de commande, tel que le calculateur évoqué ci-dessus.

Enfin, le boîtier doit être conformé pour présenter un dégagement, en forme de baignoire, de réception des extrémités libres des pattes de connexion du connecteur.

La présente invention vise à pallier tous ces inconvénients.

A cet effet, elle concerne un boîtier du type mentionné ci-dessus, dans lequel le substrat métallique de drainage comporte une découpe pour former deux prolongements lateraux servant de supports au connecteur qui est soudé sur la face du circuit imprimé tournée vers le substrat au droit de la découpe.

L'invention est remarquable par le fait que le connecteur est fixé au boîtier indirectement par l'intermédiaire du substrat et que l'assemblage circuit imprimé-connecteur, avant fixation au boîtier, n'est plus souple et que, finalement, le connecteur classique du boîtier de l'invention est utilisé pour ainsi dire en composant CMS inverse, c'est-à-dire avec une face de soudage de circuit imprimé opposée à celle des composants CMS.

Grâce à l'invention, on peut utiliser un connecteur classique et le fixer rapidement au substrat ; son montage est ainsi grandement simplifié. Après soudage des composants et du connecteur, l'ensemble, rigide, peut être facilement fixé au boîtier.

De préférence, la découpe du substrat est ménagée depuis la partie médiane d'un bord.

De préférence encore, le connecteur est séparé des composants dissipateurs par une lèvre de blindage électromagnétique.

De préférence toujours, le boîtier est ouvert du côté de la face du substrat opposée à sa face de fixation du circuit imprimé, ce qui supprime toute résistance thermique entre le boîtier et le substrat et améliore la capacité de dissipation thermique.

L'invention sera mieux comprise à l'aide de la description suivante de la forme de réalisation préférée du boîtier de l'invention, en référence au dessin annexé, sur lequel :

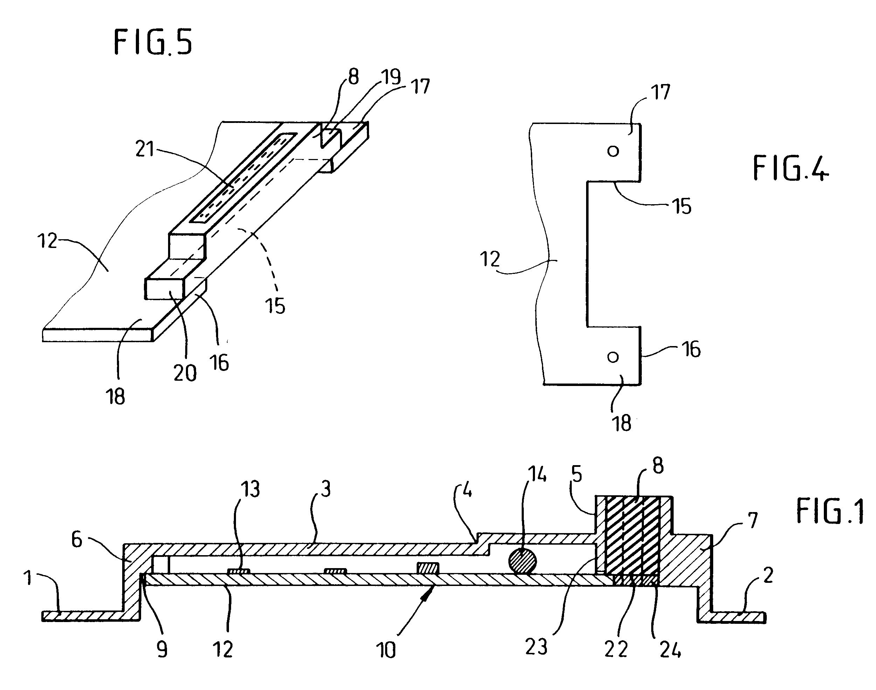

- la figure 1 est une vue en coupe longitudinale du boîtier ;
- la figure 2 est une vue de dessous de la partie du boîtier, support de composants ;
- la figure 3 est une vue analogue à celle de la figure 2, après fixation du support ;
- la figure 4 est une vue de dessus du bord du substrat, support du connecteur et
- la figure 5 est une vue en perspective du bord du substrat de la figure 4, après fixation du connecteur.

Le boîtier, qui va maintenant être décrit, est ici un boîtier moulé en aluminium, de forme générale parallélépipédique à fond ouvert et qui présente, à ses deux extrémités longitudinales, des pattes de fixation 1,2. Entre les pattes de fixation, s'étend une paroi de fond supérieure 3, faisant office de couvercle.

Pour tenir compte des divers encombrements de composants, la paroi 3 présente un premier épaulement transversal 4. Pour tenir compte de l'encombrement du connecteur 8, dont il sera question ci-après, la paroi 3 présente un second épaulement transversal 5, plus élevé que le premier. La paroi 3 est raccordée aux pattes de fixation, d'un côté, par une paroi latérale transversale simple 6 et, de l'autre côté, par une paroi latérale transversale épaisse et plus haute 7, pour servir, avec l'épaulement 5, de maintien au connecteur 8. Un épaulement intérieur 9 de réception du support de composants 10, dont il sera aussi question ci-après, est ménagé sur la paroi latérale transversale 6 et les deux parois latérales longitudinales du boîtier, sensiblement à mi-hauteur de la paroi 6 et jusqu'au droit du deuxième épaulement 5.

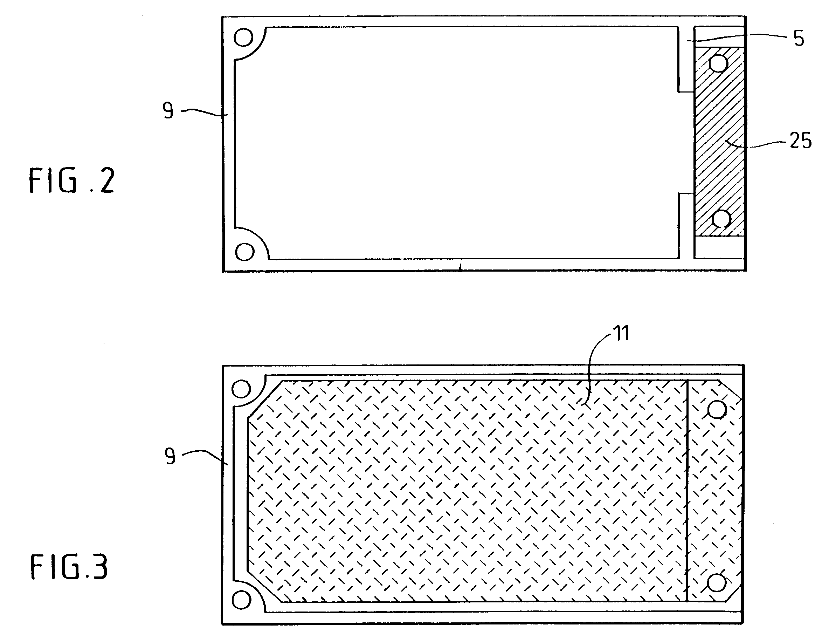

Le boîtier contient, en appui contre l'épaulement 9, le support de composants 10 constitué d'un circuit imprimé double face 22, dont l'empreinte 11 est représentée sur la figure 3, fixé sur un substrat métallique 12, de drainage thermique, tourné vers l'ouverture du boîtier. Des composants électroniques CMS dissipateurs d'énergie sont soudés sur la face du circuit imprimé tournée vers la paroi 3, certains 13 de relativement faible hauteur, d'autres 14, entre les deux épaulements 4,5, de hauteur plus importante.

Le substrat 12 est percé d'une découpe 15, ici rectangulaire, ménagée depuis la partie médiane d'un bord transversal 16 du substrat 12 pour former deux prolongements latéraux 17, 18 servant de supports aux deux pattes de fixation 19, 20 du connecteur 8, dont l'ensemble des bornes de connexion 21 se trouve au droit de la découpe 15 et d'une partie du circuit imprimé 22 auquel elles sont soudées par sa face tournée vers le substrat 12, c'est-à-dire la face autre que celle des composants 13, 14. L'empreinte 25 du connecteur 8 sur le circuit imprimé 22 est représentée sur la figure 2.

Le connecteur 8 est séparé des composants 13, 14 par une lèvre de blindage électromagnétique 23 prolongeant, vers l'ouverture du boîtier, l'épaulement 5.

Le boîtier est facile à réaliser. On moule le boîtier proprement dit, ici en aluminium. On prend un flanc rectangulaire d'aluminium, pour former le substrat de drainage 12, et on réalise la découpe 15 ménageant les prolongements 17, 18. On prend une plaquette flexible isolante, en polymide par exemple, sur les deux faces de laquelle on imprime des pistes conductrices, pour former le circuit imprimé double face 22, de dimensions seulement très légèrement inférieures à celles du substrat 12. On y perce les orifices pour trous métallisés. On fixe le cicuit 22 au substrat 12, ici par collage. On pose les composants 13, 14 sur la face du circuit 22 destinée à être tournée vers la paroi de boîtier 3 et on les soude sur cette face. On pose le connecteur 8, par ses pattes 19, 20, sur la même face du circuit 22 que les composants 13, 14, on fixe les pattes aux prolongements 17, 18 du substrat 12 et on soude ses bornes de connexion 21 sur l'autre face du circuit 22. On introduit l'ensemble dans le boîtier et on l'y fixe contre l'épaulement 9. Enfin, et à titre de protection, on dépose une goutte de résine 24 contre les points de soudure des bornes du connecteur 8. Le substrat 12 ferme ainsi le boîtier 3.

## Revendications

1. Boîtier récepteur de composants électroniques (13,14) dissipateurs d'énergie montés sur un circuit imprimé double face (22) qui est fixé à un substrat métallique (12) de drainage thermique solidaire du boîtier et auquel est relié électriquement un connecteur (8), aussi solidaire du boîtier et disposé du même côté du substrat (12) que le circuit imprimé (22), le substrat métallique de drainage (12) comportant une découpe (15) pour former deux prolongements latéraux (17,18) servant de supports au connecteur (8) qui est soudé sur la face du circuit imprimé (22) tournée vers le substrat (12) au droit de la découpe (15).

2. Boîtier selon la revendication 1, dans lequel la découpe (15) du substrat (12) est ménagée depuis la partie médiane d'un bord (16).

3. Boîtier selon l'une des revendications 1 et 2, dans lequel le connecteur (8) est séparé des composants dissipateurs (13, 14) par une lèvre (23) de blindage électromagnétique.

4. Boîtier selon l'une des revendications 1 à 3, dans lequel le boîtier est ouvert du côté de la face du substrat (12) opposée à sa face de fixation du circuit imprimé (22).

## Patentansprüche

1. Gehäuse zur Aufnahme elektronischer Bauteile (13, 14), die Energie abgeben und auf einer doppelseitigen gedruckten Schaltung (22) montiert sind, welche an einem Metallsubstrat (12) befestigt ist, das zur Wärmeableitung in einem Stück mit dem Gehäuse ausgebildet ist und an das ein Verbinder (8) elektrisch angeschlossen ist, der ebenfalls in einem Stück mit dem Gehäuse ausgebildet und auf derselben Seite des Substrates (12) wie die gedruckte Schaltung (22) angeordnet ist,
wobei das wärmeableitende Metallsubstrat (12) eine Aussparung (15) aufweist, die zwei seitliche Verlängerungen (17, 18) bildet, welche Träger für den Verbinder (8) bilden, der auf der Seite der gedruckten Schaltung, die dem Substrat (12) gegenüberliegt, auf der Höhe der Aussparung (15) aufgelötet ist.

2. Gehäuse nach Anspruch 1,
bei dem die Aussparung (15) des Substrats (12) vom mittleren Bereich eines Randes (16) ausgehend angebracht ist.

3. Gehäuse nach einem der Ansprüche 1 und 2,
bei dem der Verbinder (8) von den energieabgebenden Bauteilen (13, 14) durch eine Leiste (23) zur elektromagnetischen Abschirmung getrennt ist.

4. Gehäuse nach einem der Ansprüche 1 bis 3,
bei dem das Gehäuse von derjenigen Seite des Substrates (12) aus offen ist, die der Seite der Befestigung der gedruckten Schaltung (22) gegenüberliegt.

## Claims

1. Casing for receiving power-dissipating electronic components (13, 14) mounted on a double-sided printed circuit (22) which is fixed to a metal substrate (12) for thermal drainage integral with the casing and to which a connector (8) is electrically connected, also integral with the casing and disposed on the same side of the substrate (12) as the printed circuit (22), the metal drainage substrate (12) comprising a cut-out (15) in order to form two lateral extensions (17, 18) serving as supports for the connector (8) which is soldered to the side of the printed circuit (22) facing the substrate (12) in line with the cut-out (15).

2. Casing according to Claim 1, in which the cut-out (15) in the substrate (12) is provided from the central part of one edge (16).

3. Casing according to one of Claims 1 and 2, in which the connector (8) is separated from the dissipating components (13, 14) by an electromagnetic screening lip (23).

4. Casing according to one of Claims 1 to 3, in which the casing is open from the side of the face of the substrate (12) opposite its face for the fixing of the printed circuit (22).
